# EUROPEAN PATENT APPLICATION

(11) **EP 1 143 254 A1**
(43) Date of publication of application: **10.10.2001**
(21) Application number: 01108111.4
(22) Date of filing: 30.03.2001
(51) Int. Cl.: G01R 31/02

(54) **Earth wiring diagnosis in circuit modules with multiple earth connection, particularly for electronic units on board motor vehicles**

(30) Priority: 04.04.2000 IT TO000316
(71) Applicant: MAGNETI MARELLI S.p.A., 20145 Milano (IT)
(72) Inventor: Marietta Bersana, Daniele, 10073 Cirié (Torino) (IT); Giorgetta, Valerio, 10154 Torino (IT); Sappé, Levi, 10030 Villareggia (Torino) (IT); Carlevaris, Alberto, 10152 Torino (IT)
(74) Representative: Quinterno, Giuseppe

(57) **Abstract**

A circuit and a process for diagnosis of the earth wiring in a circuit module comprising a plurality of sections (11, 12), each with a respective reference conductor (GND₁, GND₂), capable of being connected separately to the common earth conductor (GND_{CH}) through a respective electrical path is described.

The circuit comprises a plurality of branches each coupled in series with a respective electrical connection path to the common earth conductor (GND_{CH}); a circuit for supply of a control current (I_{P}) to these branches; and a plurality of detection resistances (R_{S1}/ R_{S2}) each associated with respective branch for detecting a current flowing in it towards the common earth conductor (GND_{CH}). The diagnosis process provides for supplying a control current (I_{P}) to the said diagnosis circuit branches and detecting the current flowing in them following supply of this current. The flow of current in these branches following supply of the control current (I_{P}) is indicative of the electrical continuity of the respective electrical paths to the earth common conductor (GND_{CH}) .

## Description

The present invention relates to the diagnosis of earth wiring in circuit modules with multiple earth connection, and specifically a circuit and a process for the diagnosis of earth wiring as defined in the introductory part of Claims 1 and 14.

In particular the subject of the invention is a diagnosis circuit capable of being utilised in electronic control units on board motor vehicles. Such units generally have at least one signal processing section and one power section for controlling actuators, each of which is associated with a respective earth reference conductor connected individually, via an associated terminal, to the chassis of the motor vehicle which acts as a common earth.

In electronic control units with two earth terminals the disconnection of one only of the two wires constituting the earth wiring is not currently diagnosed.

Since the double connection to earth is intended as a safety arrangement the possibility of diagnosing disconnection of even only one of the wires (let alone both) of the wiring is as important as the introduction of the wiring redundancy itself.

The object of the present invention is that of providing a reliable arrangement which improves the safety of the onboard electronics, obviating the disadvantages of the prior art. According to the present invention this object is achieved by an earth wiring diagnostic having the characteristics set out in Claim 1, as well as a diagnosis procedure as claimed in Claim 14.

Particular embodiments of the invention are defined in the sub-claims.

In summary, the present invention is based on the principle of checking the electrical continuity of the connections to a common earth conductor to which all the reference conductors of a control unit are separately wired, by supplying a control current to the common earth conductor through paths determined by the said connections and verifying the flow of current through all the paths.

For this purpose there is provided a diagnosis circuit in which a plurality of circuit branches provided with respective sensor elements for detecting the flow of a current are disposed in such a way as to form a corresponding plurality of separate paths to earth which are completed through the said connections. The sensor elements are formed simply as resistances, and the local voltage drop across the ends of such resistances is detected after the application of the control current.

The establishment of a voltage drop across a resistance as a consequence of the flow of a portion of the control current towards the common earth is interpretable as an indication of the electrical continuity of the associated connection.

In the preferred embodiment the determination of the voltage takes place in a differential manner by comparing the potential differences across the said resistances in two successive operating states, respectively with and without the application of a current pulse. Disconnection of an earthing circuit (path to common earth interrupted) is diagnosed when the outcome of this comparison is that a current path has made no contribution, that is to say no current flows along the path including this resistance.

Further characteristics and advantages of the invention will be explained in more detail in the following detailed description of a preferred embodiment, given purely by way of non-limitative example, with reference to the attached drawings in which:

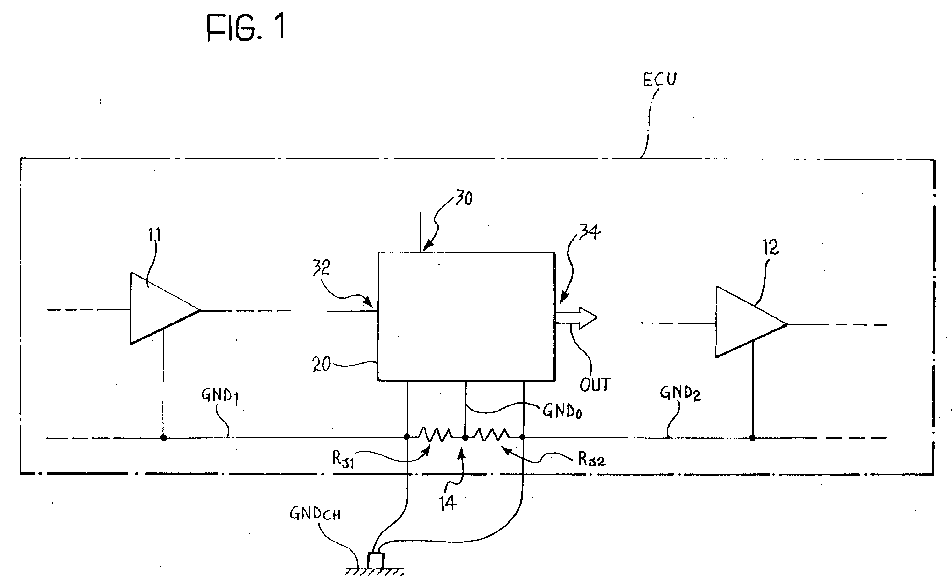

Figure 1 is an overall circuit diagram in which a circuit according to the invention is shown disposed in an electronic control unit; and
Figure 2 is a detailed circuit diagram of the circuit of Figure 1.

In an electronic control unit ECU the signal section and the power section are generally indicated 11 and 12. A first earth conductor GND₁ and a second earth conductor GND₂ are provided, respectively, with reference conductors for each of the two sections. To these are associated respective terminals P1 and P2 for the wiring and a common earth conductor GND_{CH} in the example the chassis of a motor vehicle.

The conductors GND₁ and GND₂ are coupled together via a connection 14 having a low resistivity of known value, indicated here as comprising a series of resistors R_{S1} and R_{S2} the significance of which will be discussed further hereinafter.

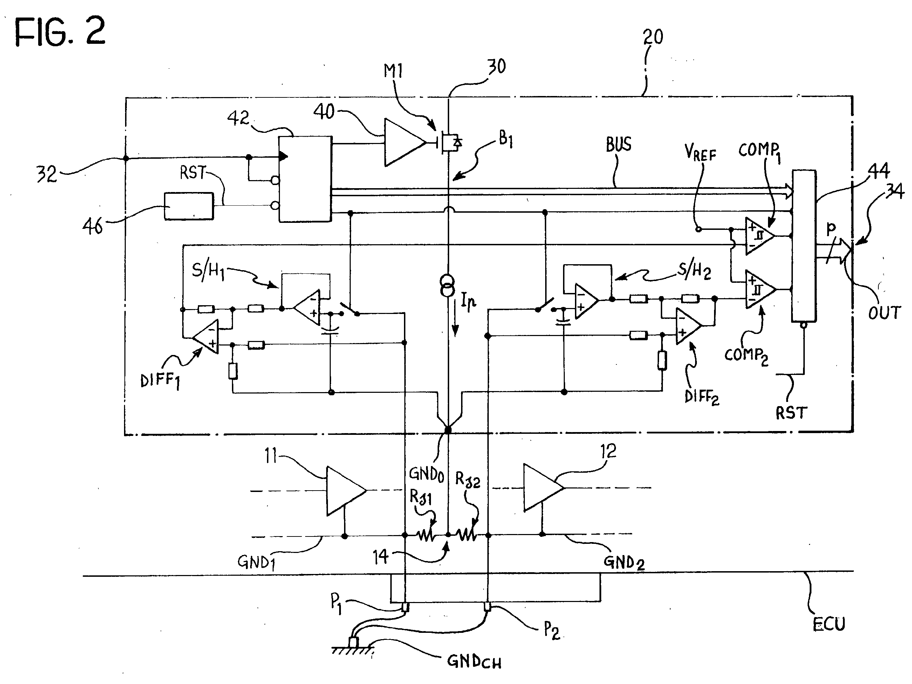

A diagnosis circuit according to the invention comprises a main module generally indicated 20, illustrated in detail in Figure 2.

This module is coupled to an electrical source, such as for example the motor vehicle battery, via a supply input 30, whilst a signal input 32 is arranged to receive an activation signal for activating the diagnosis operation, generated by the control unit ECU. The module 20 provides, at an output 34, a word OUT formed by p parallel bits, in which the information on the result of the diagnosis operation is coded, for example for subsequent processing by the same control unit ECU.

The earth conductors GND₁ and GND₂ are coupled to a common reference conductor, indicated GND₀ of the diagnosis circuit via circuit branches comprising detection resistances R_{S1} and R_{S2} which, in the embodiment discussed in this description branch from a low resistivity connection 14. These resistances can be formed by the lines of interconnection of the control unit ECU or by discrete resistive components, for example formed by silk screen printing on ceramic supports. They therefore constitute a path from the common reference conductor GND₀ of the diagnosis circuit towards the common earth conductor GND_{CH}.

If the control unit ECU is provided with a number of earth conductors GNDᵢ (i = 1, 2,...) greater than two, the detection resistances will be disposed in a star configuration, the star centre being the common conductor GND₀, in which each resistance will lead to a respective earth conductor GNDᵢ.

Referring now to Figure 2, the main module 20 of the diagnosis circuit comprises:
a supply portion for supplying a control current to the common earth conductor GND_{CH} to which the earth conductors GNDᵢ (i = 1,2,...), are separately wired through the detection resistances R_{S1} and R_{S2} for analysis of the electrical continuity of the path to earth of the individual connections;
two portions (shown as mirror images) for the detection of a current flowing through each of these resistances, that is to say along each circuit path comprising a connection to the common earth GND_{CH}, following application of the control current;
an interpretation and coding portion for coding the condition of the presence (absence) of electrical continuity of the earth connections as a function of the presence (absence) of the said current; and
a control portion for management of a diagnosis operation comprising the above-described steps.

The control current supply portion comprises a circuit branch B₁ disposed between the supply input 30 and the common conductor GND₀ in which there is a MOSFET transistor M₁. A piloting circuit 40 is coupled to the transistor M₁ through the gate electrode of this latter to control its switching as a function of the control signals imparted by an upstream control logic circuit 42, and in this way to determine the injection of current pulses I_{P}.

Each portion for the detection of the current flowing in the connections towards common ground GND_{CH} comprises a sample/hold circuit (respectively S/H₁ and S/H₂) piloted by the control logic circuit 42 operable to sample, at predetermined intervals, the voltage present on a corresponding earth conductor GND₁ or GND₂ of the control unit ECU with respect to the common reference conductor GND₀. As will be obvious to one skilled in the art, in this embodiment of diagnosis circuit such voltage is no more than the potential difference present across the terminals of the associated detection resistance.

Downstream of each sample and hold circuit S/H₁, S/H₂, is provided a differential amplifier, respectively DIFF₁ and DIFF₂, formed according to criteria widely known in the art. The inverting input of such amplifier is coupled to the output of the respective sample and hold circuit whilst the non-inverting input is coupled directly to the corresponding earth conductor, the voltage of which is periodically sampled by the sample and hold circuit.

The interpretation and coding portion comprises a threshold comparator coupled to the output of each differential amplifier. In the illustrated example there are therefore two comparators, respectively indicated COMP₁ and COMP₂. Each of these comparators receives at its inverting input the output signal from the corresponding differential amplifier, and at its non-inverting input a reference voltage signal V_{REF}.

A sequential logic circuit 44 has a pair of inputs intended to receive the outputs of the threshold comparators COMP₁ and COMP₂, as well as an input to receive the piloting signal for each sample and hold circuit S/H₁ and S/H₂ coming from the control logic circuit 42.

The control logic circuit 42 is coupled directly to the sequential logic circuit 44 via a further set of connections indicated by the reference BUS in Figure 2.

The sequential logic circuit 44, at the output 34 of the module 20 of the diagnosis circuit, emits the coded word OUT composed of *p* bits.

Finally, the control portion for management of the diagnosis operation comprises the previously mentioned control logic circuit 42.

In more detail, this circuit receives at a pair of synchronisation inputs the diagnosis operation activation signal generated by the control unit ECU, and the same signal inverted, at the signal input 32 of the diagnosis circuit.

A supply detector circuit 46 is coupled to a further input terminal of the control circuit 42 and to the sequential logic circuit 44 for the transmission of a reset signal RST in such a way as to force these circuits into a defined condition each time the control unit is supplied.

In a configuration without any breaks, in which the control unit ECU is connected to the common earth conductor GND_{CH} via the terminals P1 and P2 and the associated wiring, the currents in the signal section 11 and power section 12 which flow to the respective earth conductors GND₁ and GND₂ are each connected to the common earth GND_{CH} through the electrical connection path relative to its section.

If a breakage occurs such that disconnection of only one of the two wires constituting the earth cable occurs, no significant alteration in the operation of the control unit manifests itself, although the level of security is compromised. In fact, the currents in the section in which the earth conductor GNDᵢ is no longer connected to the common earth GND_{CH} will be connected through the low resistivity connection 14 and the associated path to the earth conductor of the other sections.

In such circumstances the diagnosis circuit 20 according to the invention is sensitive to the unbalancing of the current flow regime thanks to the arrangement of the detection resistances R_{S1} and R_{S2} along the possible paths to the common earth GND_{CH}, and can interpret this unbalancing as a loss of electrical continuity in one earth connection.

The diagnosis circuit is in fact arranged to detect the potential drops across the terminals of the detection resistances R_{S1} and R_{S2} following the application of control current and to deduce from these the presence (or absence) of currents flowing in the different circuit paths towards the common earth GND_{CH}, and therefore the electrical continuity of the individual connections.

In particular, the reading of the potential drops across the resistances R_{S1} and R_{S2} occurs in a differential manner in order to identify the individual contributions due to the injection of the current pulses Ip and to exclude the contributions normally due to the potential difference existing between each earth conductor GNDᵢ and the common reference conductor GND₀, as well as those due to the recirculation currents coming from sections of the earth conductor GNDᵢ which are no longer connected to the common earth GND_{CH}.

When the control unit ECU decides to start a diagnosis operation (which can occur periodically as long as the control unit has previously been programmed in this way), an activation signal, for example in the form of a pulse, is sent to the input 32 of the diagnosis circuit 20 and through this to the control logic circuit 42.

The control logic circuit 42 then controls the sampling of the localised voltages across the detection resistances R_{S1} and R_{S2}. This operation is demanded at the sample and hold circuits S/H₁ and S/H₂.

After the time necessary to effect sampling has passed the control circuit 42, by controlling the transistor M1 to switch, forces the injection of a current pulse I_{P} of several amps from the supply input 30 to the common node GND₀ of the resistances R_{S1} and R_{S2}.

If both the terminals P1 and P2 are connected to the common earth conductor GND_{CH} the current divides across both the resistances. At the inverting and non-inverting inputs of the differential amplifiers DIFF₁ and DIFF₂ there are present potential drops across the terminals of the resistances R_{S1} and R_{S2} respectively before and after the injection of the current, and both the amplifiers provide at the output a voltage significantly different from zero, due to the contribution caused by I_{P}.

It will be clear to one skilled in the art that, by virtue of the choice of performing the reading of the potential drops on the resistances R_{S1} and R_{S2} in a differential manner, the precision with which the division of I_{P} takes place is of little significance, it being necessary only to detect if its contribution exists or not. If one of the earth connections is missing, for example that relating to the conductor GND₁, the corresponding detection resistance R_{S1} is not traversed by a portion of the current I_{P}, through the terminal P1 and the corresponding differential amplifier DIFF₁ emits at its output a substantially nil voltage.

Obviously, the reasoning is analogous in the case of disconnection of the earth connection of the conductor GND₂.

The output voltages provided by the differential amplifiers DIFF₁ and DIFF₂ are compared with a reference voltage V_{REF} by means of the associated threshold comparators COMP₁ and COMP₂.

The logic state present at the output of the comparators at the end of the current pulse I_{P} will then indicate the presence or absence of the earth connections.

The sequential logic circuit 44 receives and codes the information present on the outputs of the comparators COMP₁ and COMP₂ at sampling instants determined by diagnosis operation activation signal edges present at the input 32 of the diagnosis circuit.

The information about the result of the diagnosis of the earth wiring, and that possibly derived through the connections BUS about the internal diagnosis of the circuit 20, is output on the word OUT.

Naturally, the principle of the invention remaining the same, the embodiments and details of construction can be widely varied with respect to what has been described and illustrated purely by way of non-limitative example, without by this departing from the ambit of protection of the present invention.

This is true in particular, as far as the possibility of different embodiments having a different number of earth connections which consitute the wiring to be diagnosed is concerned. The number of detection resistances R_{Si} (i = 1,2,...) is chosen to establish a plurality of paths from the common reference conductor GND₀ of the diagnosis circuit to the common earth conductor GND_{CH}, each through the terminal and the wiring portion of an earth conductor GNDᵢ (I = 1,2,...) of the control unit ECU.

Each detection resistance will correspond to a respective portion of the diagnosis circuit for the detection of the current flowing through it, with a sample and hold circuit, differential amplifier, and threshold comparator. The sequential logic circuit 44 will be formed in conformity, by applying design techniques known per se to allow the treatment of the increased quantity of information.

Advantageously, the diagnosis circuit as a whole may be formed on a single integrated circuit of small dimensions. The arrangements according to the invention therefore make it possible to manage diagnosis of the disconnection of the earth connection in circuit modules with double or multiple wiring in a reliable manner and with reduced occupation of space.

In the last analysis, this involves an improvement in the performance of the electronics on board motor vehicles in terms of the security of their occupants.

## Claims

1. A circuit for diagnosis of the earth wiring in a circuit module (ECU) comprising a plurality of sections (11, 12) each with a respective reference conductor (GND₁, GND₂) capable of being connected separately to a common earth conductor (GND_{CH}) through a respective electrical path, **characterised in that** it comprises:
a plurality of circuit branches, each being connectable substantially in series with a respective electrical connection path to the common earth conductor (GND_{CH}) so as to form a diagnosis path to the said conductor;
means (30 M1) for supply of a control current I_{P} to the said plurality of circuit branches; and
current detector means (R_{S1}, R_{S2}; S/H₁, S/H₂; DIFF₁, DIFF₂) associated with each circuit branch to detect a current flowing in it towards the common earth conductor (GND_{CH}) following a supply of the control current (Iₚ), this current being indicative of the electrical continuity of the electrical paths to the common earth conductor (GND_{CH}).

2. A circuit according to Claim 1, **characterised in that** the current detector means comprise at least one element of substantially resistive characteristic (R_{S1}; R_{S2}) disposed in each circuit branch such that the current is detected by the localised voltage drop across the said element (R_{S1}; R_{S2}).

3. A circuit according to Claim 1 or Claim 2, **characterised in that** the said circuit branches are coupled together to a common node (GND₀) of the circuit, to which the control current (I_{P}) is supplied.

4. A circuit according to Claim 2, in which the current in the circuit branches is detected in a differential manner, by comparing the localised voltage drops across each element of resistive characteristic (R_{S1}; R_{S2}) in two successive operating states, respectively without and with supply of a control current (I_{P}) .

5. A circuit according to any preceding claim, **characterised in that** the control current (I_{P}) is supplied in pulses.

6. A circuit according to Claim 4, in which the current detector means associated with each circuit branch comprise:
a signal sampling circuit (S/H₁; S/H₂), coupled to a respective resistive element (R_{S1}; R_{S2}) and operable to sample and maintain at its output the voltage which is established across this element (R_{S1}; R_{S2}) in an operating state without supply of the control current (Ip); and
a differential amplifier circuit (DIFF₁; DIFF₂) which receives at a first input the voltage sampled by the said sampling circuit (S/H₁; S/H₂) and at a second input the voltage which is established across the said resistive element (R_{S1}; R_{S2}) following supply of the control current (Iₚ),
the said amplifier circuit (DIFF₁; DIFF₂) being arranged to emit an output signal indicative of the difference between the voltages across the resistive element (R_{S1}; R_{S2}) detected in the two operating states.

7. A circuit according to Claim 6, **characterised in that** it comprises a plurality of comparator circuits (COMP₁, COMP₂) each able to receive, at a first input, the output of the respective differential amplifier circuit (DIFF₁, DIFF₂) and, at a second input, a predetermined reference voltage (V_{REF}), the said comparator circuits (COMP₁, COMP₂) each being operable to emit a logic signal indicative of the interruption of the electrical continuity of a respective path to the common earth conductor (GND_{CH}) for which the said signal assumes a first logic value when the difference between the voltages detected across the terminals of the corresponding resistive element (R_{S1}, R_{S2}) in the two operating states is substantially nil, and a second logic value when this difference is significantly different from zero.

8. A circuit according to Claim 7, **characterised in that** it includes a coded logic circuit (44) comprising a plurality of inputs to which the said comparator circuits (COMP₁, COMP₂) are coupled, the said circuit being operable to emit an overall coded signal (OUT) carrying information about the result of the diagnosis operation on the earth wiring.

9. A circuit according to Claim 8, **characterised in that** it includes a control logic circuit (42) operable to receive at an input a diagnosis operation activation signal and to emit at an output at least one first sampling operation control signal to the sampling circuits (S/H₁, S/H₂) and a second signal for controlling supply of the current to the circuit branches.

10. A circuit according to claim 9, in which the coded logic circuit (44) includes a control input able to receive the said sampling operation control signal.

11. A circuit according to any of the claims from 2-10, in which the element of resistive characteristic (R_{S1}, R_{S2}) is a printed circuit interconnection line.

12. A circuit according to any claims from 2-10, in which the element of resistive characteristic (R_{S1}, R_{S2}) is a discrete resistor.

13. A circuit according to any preceding claim, **characterised in that** it is formed as a semi-conductor integrated circuit.

14. A process for the diagnosis of the earth wiring in a circuit module comprising a plurality of sections (11, 12) each with a respective reference conductor (GND₁, GND₂) capable of being connected separately to a common earth conductor (GND_{CH}) through a respective electrical path, **characterised in that** it comprises the operations of:
providing a plurality of diagnosis circuit paths each including a corresponding electrical path to the said common conductor (GND_{CH}) ;
associating with each of the said paths corresponding current detector means (R_{S1}, R_{S2}; S/H₁, S/H₂; DIFF₁, DIFF₂);
supplying a control current (I_{P}) to the said plurality of diagnosis circuit paths; and
detecting the current flowing in the said paths towards the common earth conductor (GND_{CH}) following supply of the control current (I_{P}), this current being indicative of the electrical continuity of the electrical path to the said conductor (GND_{CH}).

15. A process according to claim 14, in which the current detector means comprise at least one element (R_{S1}, R_{S2}) having a substantially resistive characteristic disposed in each diagnosis path so that the current is detected by the localised voltage drop across the said element (R_{S1}, R_{S2}).

16. A process according to claim 15, in which the current is detected in a differential manner by comparing the localised voltage drop across an element (R_{S1}, R_{S2}) of resistive characteristic in two successive operating states, respectively without and with the supply a control current (I_{P}).

17. A process according to claim 16, comprising in succession the operation of:
sampling the voltage which is established across the terminals of each resistive element (R_{S1}, R_{S2}) in one operating state without supply of the control current (I_{P});
supplying the control current (Ip) to the plurality of the diagnosis circuit paths;
detecting the voltage across the terminals of each resistive element (R_{S1}, R_{S2}) following supply of the said current (I_{P}); and
producing a corresponding plurality of signals indicative of the difference between the voltages detected in the two operating states.

18. A process according to claim 17, in which the interruption of the electrical continuity of one path to the common earth conductor (GND_{CH}) is evaluated as a function of the difference between the voltages detected across the terminals of the associated resistive element (R_{S1}, R_{S2}), in the two operating states, by which the electrical continuity of a path is recognised when this difference is significantly different from zero, or the interruption of the electrical continuity when this difference is substantially nil.
